# EUROPEAN PATENT SPECIFICATION

(11) **EP 2 767 840 B1**
(45) Date of publication and mention of the grant of the patent: **06.12.2017**
(21) Application number: 12840055.3
(22) Date of filing: 11.10.2012
(51) Int. Cl.: H02S 50/10, G01R 1/04

(54) **MEASUREMENT JIG FOR SOLAR BATTERY AND METHOD FOR MEASURING OUTPUT OF SOLAR BATTERY CELL**
MESSVORRICHTUNG FÜR EINE SOLARBATTERIE UND VERFAHREN ZUR MESSUNG DER LEISTUNG EINER SOLARBATTERIEZELLE
MONTAGE DE MESURE POUR BATTERIE SOLAIRE ET PROCÉDÉ DE MESURE DE SORTIE DE CELLULE DE BATTERIE SOLAIRE

(30) Priority: 13.10.2011 JP 2011226096; 19.06.2012 JP 2012137951
(43) Date of publication of application: 20.08.2014
(73) Proprietor: Dexerials Corporation, Tokyo 141-0032 (JP)
(72) Inventor: HIGUCHI, Akifumi, Shinagawa-ku, Tokyo 141-0032 (JP); OKUMIYA, Hideaki, Tokyo 141-0032 (JP)
(74) Representative: Müller Hoffmann & Partner
(86) International application number: PCT/JP2012/076352
(87) International publication number: WO 2013/054855

(56) References cited:
- EP-A2- 1 052 704
- JP-A- 2006 118 983
- JP-A- 2008 071 989
- JP-A- 2011 099 746
- US-A1- 2007 068 567
- US-A1- 2010 201 349

## Description

### Field of the Invention

This invention relates to a measurement jig for measuring electrical characteristics of a solar battery module and a measuring method thereof, and more particularly concerns improvements of an electrode terminal structure that is made in contact with a solar battery cell.

### Background of the Invention

Conventionally, as the measurement jig for use in measuring electrical characteristics of a solar battery cell, in general, a measurement jig provided with a plurality of probe pins that are made in contact with bus bar electrodes of the solar battery cell has been used. The measurement jig of this type has current measuring probe pins for measuring an electric current flowing through the solar battery cell and voltage measuring probe pins for measuring a voltage that is generated in the solar battery cell.

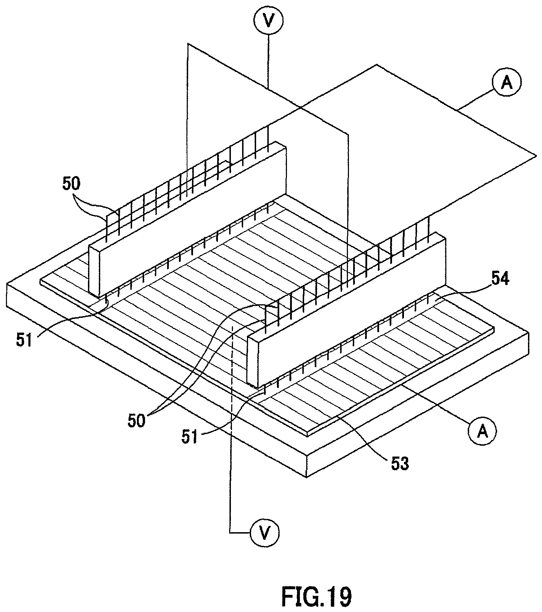

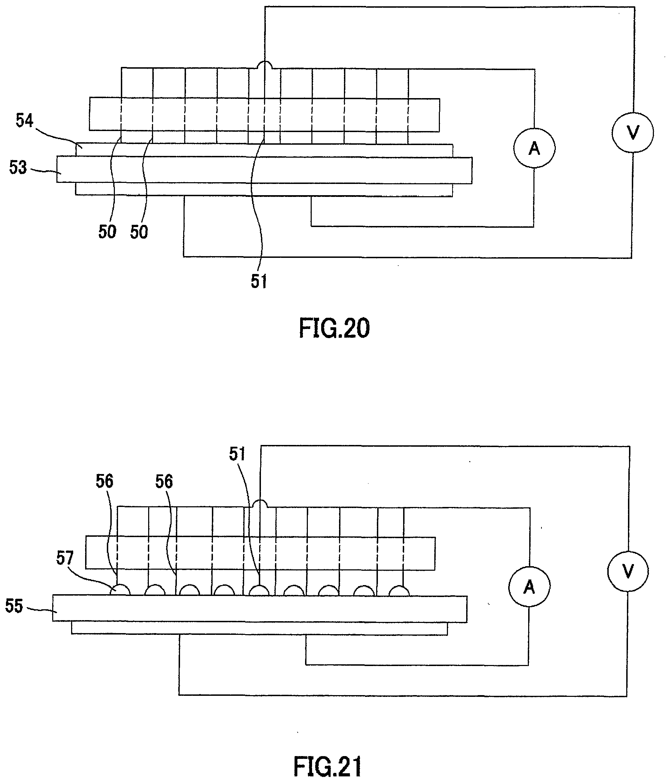

For example, as shown in Figs. 19 and 20, the measurements of electrical characteristics of the solar battery cell are carried out by using a so-called four terminal method in which these current measuring probe pins 50 and voltage measuring probe pins 51 are made in contact with bus bar electrodes 54 of a solar battery cell 53 to be measured, and while irradiating a light-receiving surface of the solar battery cell 53 with pseudo-solar light, an electric current flowing through the solar battery cell 53 and a voltage generated in the solar battery cell 53 are measured.

Japanese Patent Application Laid-Open No. 2006-118983 discloses a measurement fixture for a solar battery cell which prevents a decrease in a curve factor and reduces losses in time and a cost for replacing probe pins, where a bus bar electrode is provided on an n-type semiconductor. A probe bar is provided with a voltage measurement probe pin and a current measurement probe pin which retract upward when they are brought into contact with the bus bar electrode from above for the measurement of a solar battery cell.

US 2010/201349 A1 provides a method for measuring I-V characteristics of a solar cell, the solar cell comprising a plurality of fine line-shaped electrodes formed on a first surface in a predetermined direction; and a coupling line formed on the first surface that electrically couples at least two fine line-shaped electrodes among the plurality of fine line-shaped electrodes, the coupling line having a line width larger than a line width of the fine line-shaped electrodes.

EP 1 052 704 A2 discloses a everse biasing apparatus used to remove short-circuited portions in a solar battery module having multiple strings of solar cells each including a first electrode layer, a photovoltaic semiconductor layer and a second electrode layer formed on a glass substrate, by applying a reverse bias voltage between the electrodes of adjacent solar cells. The reverse biasing apparatus comprises probes to be in contact with the electrodes of adjacent three or more strings of solar cells, an actuator for actuating the probes up and down, and a relay switch for selecting, from the probes , a pair of probes for applying the reverse bias voltage between the electrodes of an arbitrary pair of adjacent solar cells.

### Summary of the Invention

In recent years, in order to cut the number of production processes of the solar battery cell and also to cut the amount of use of electrode materials such as an Ag paste, thereby reducing the production costs, a manufacturing method has been proposed in which without installing bus bar electrodes, a tab wire serving as an interconnector is directly disposed on finger electrodes and connected thereto in a manner so as to intersect therewith, with a conductive adhesive film interposed therebetween. Also, in the case of this solar battery cell having a busbarless structure , the current collecting efficiency is kept equal to or better than that of the solar battery cell with the bus bar electrodes formed thereon.

Upon carrying out measurements of electrical characteristics on a solar battery cell 55 having such a busbarless structure, it is necessary to make probe pins 56 directly in contact with finger electrodes 57. However, as shown in Fig. 21, the installation spaces of the probe pins 56 are not coincident with the formation spaces of the finger electrodes 57 in many cases, and in this case, it is not possible to ensure conduction to all the finger electrodes 57, causing some of the finger electrodes 57 to be out of the measuring objects, consequently failing to measure electrical characteristics accurately.

In order to solve such a problem, a measuring technique has been proposed in which a rectangular plate-shaped bar electrode is used as the measuring terminal in place of using the probe pins, and disposed on a light-receiving surface of a solar battery cell so as to intersect with all the finger electrodes.

In the case of using the measuring technique using the bar electrode, it is necessary to allow the contact surface of the bar electrode to be uniformly made in contact with the respective finger electrodes; however, it becomes difficult to form the contact surface of the bar electrode with high degree of flatness and to adjust the horizontal degree of the bar electrode relative to the solar battery cell. Moreover, in the case when the heights of the finger electrodes are uneven on the inner plane of the solar battery cell, it becomes difficult to make the bar electrode in contact with all the finger electrodes with a sufficient pressure.

Therefore, an object of the present invention is to provide a solar battery measurement jig that can carry out measurements of electrical characteristics accurately not only on a solar battery cell provided with bus bar electrodes, but also on a solar battery cell having a busbarless structure, and an output measuring method for the solar battery cell.

In order to solve the above-mentioned problems, a solar battery measurement jig in accordance with the present invention is provided according to the appended claims 1-5.

Moreover, an output measuring method of the solar battery cell relating to the present invention, which uses a solar battery measurement jig as recited in claims 6-11 is also provided.

### Effects of Invention

In accordance with the present invention, by arranging the current measuring terminal and the voltage measuring terminal, the number of probe pins to be made in contact with the linear electrode can be increased, and in particular, in accordance with the solar battery measurement jig relating to the present invention, the probe pins can be made in contact with all the linear electrodes. Moreover, since the current measuring terminal and the voltage measuring terminal are formed in parallel with each other, upon measuring electrical characteristics, without widening the width of the holder, it is possible to suppress a loss of shadow caused by the holder, and consequently to prevent an output reduction.

Moreover, in accordance with the present invention, since the plural probe pins, which are disposed along the longitudinal direction of the holder, are partially overlapped with each other in an arrangement direction, it is possible to narrow the width of the holder.

### Brief Description of Drawings

Figure 1 is a perspective view showing a process for carrying out electrical measurements of a solar battery cell by a solar battery measurement jig to which the present invention is applied.
Figure 2 is a perspective view showing the solar battery measurement jig to which the present invention is applied.
Figure 3 is a bottom face view showing an arrangement of a current measuring terminal and a voltage measuring terminal.
Figure 4 is a bottom face view showing another arrangement of a current measuring terminal and a voltage measuring terminal.
Figure 5 is a side face view showing a state in which the current measuring terminal configured in a zig-zag pattern is made in contact with finger electrodes.
Figure 6 is a bottom face view showing another example of a contact portion of a probe pin.
Figure 7 is a bottom face view showing another example of a contact portion of the probe pin.
Figure 8 is a side face view showing another example of a contact portion of the probe pin.
Figure 9 is an exploded perspective view showing a solar battery cell and a solar battery module.
Figure 10 is a cross-sectional view showing the solar battery cell.
Figure 11 is a bottom face view showing a back surface of the solar battery cell.
Figure 12 is a cross-sectional view showing a conductive adhesive film.
Figure 13 is a view for use in explaining a current measuring process by the solar battery cell measuring device.
Figure 14 is a view for use in explaining a voltage measuring process by the solar battery cell measuring device.
Figure 15 is a perspective view showing another solar battery measurement jig.
Figure 16 is a bottom face view showing an arrangement of probe pins of another solar battery measurement jig.
Figure 17 is a bottom face view showing an arrangement of probe pins of another solar battery measurement jig.
Figure 18 is a perspective view showing another solar measurement jig.
Figure 19 is a perspective view showing a state in which electrical characteristics of a solar battery cell are measured by using a measuring device in which conventional probe pins are used.
Figure 20 is a view for use in explaining measurements by using the measuring device in which conventional probe pins are used.
Figure 21 is a view for use in explaining measurements of electrical characteristics of a solar battery cell having a busbarless structure by using the measuring device in which conventional probe pins are used.

### Detailed Description of the Invention

Referring to Figures, the following description will discuss a solar battery measurement jig that the present invention is applied and an output measuring method of a solar battery cell. Additionally, the present invention is not intended to be limited only by the following embodiments, and it is needless to say that various modifications are made therein within a scope not departing from the gist of the present invention. Moreover, Figures are schematic drawings, and the ratios or the like of the respective dimensions are sometimes different from those of actual values. Specific dimensions or the like should be determined by taking into consideration the following explanations. It is needless to say that among the Figures, portions having different relationships in dimensions and ratios are included in mutual Figures.

### [First Solar Battery Measurement Jig]

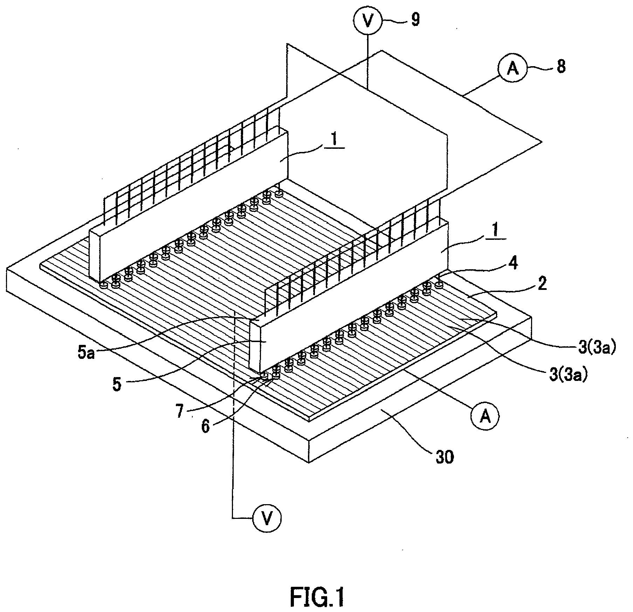

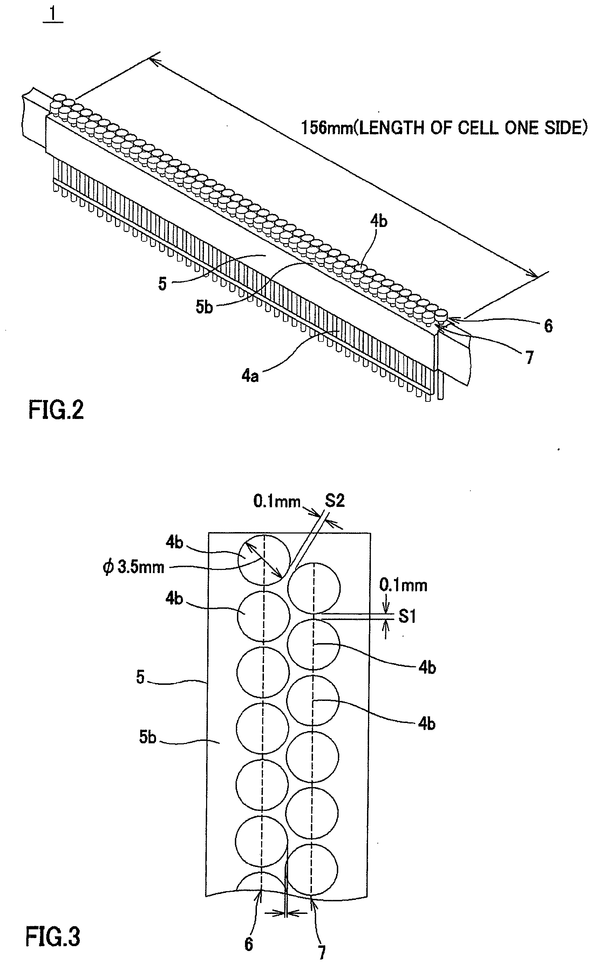

As shown in Figs. 1 and 2, a solar battery cell measurement jig 1 that the present invention is applied has a plurality of probe pins 4 that are made in contact with a surface electrode 3 formed on the surface of the solar battery cell 2 and a holder 5 for holding the probe pins 4. Moreover, the solar battery measurement jig 1 is designed so that by configuring the plural probe pins 4, a current measuring terminal 6 is formed and by configuring the plural probe pins 4, a voltage measuring terminal 7 is also formed.

Moreover, in the solar battery measurement jig 1, the plural probe pins 4 forming the current measuring terminal 6 have their terminal portions mutually connected to one another, for example, by solder connection of copper cables, and are also connected to an ampere meter 8. In the same manner, in the solar battery measurement jig 1, the plural probe pins 4 forming the voltage measuring terminal 7 have their terminal portions mutually connected to one another, for example, by solder connection of copper cables, and are also connected to a voltage meter 9.

Each of the probe pins 4 is provided with a pin main body 4a held in the folder 5 and a contact portion 4b that is attached to the tip of the pin main body 4a, and made in contact with the surface electrode 3 of the solar cell. The pin main body 4a is formed into a column shape, and the contact portion 4b is formed into a column shape having a diameter larger than that of the pin main body 4a. The probe pins 4 have their contact portions 4b protruded from a lower surface 5b of the holder 5, when the pin main bodies 4a are held by the holder 5, with the terminal portions of the pin main bodies 4a being protruded from an upper surface 5a of the holder 5. Moreover, the probe pins 4 are designed such that the terminal portions of the pin main bodies 4a protruding from the upper surface 5a of the holder 5 are mutually combined with one another by solder connection of copper cables, or the like, thereby forming the current measuring terminal 6 and the voltage measuring terminal 7 that are formed by the plural probe pins 4 arranged in a longer side direction of the holder 5.

The holder 5 holding the probe pins 4 is formed into a rectangular plate shape by using a resin material, for example, such as glass epoxy, acrylic resin, polycarbonate resin or the like. Each of the upper and lower surfaces 5a and 5b of the holder 5 is composed of a longer side corresponding to the length of one side of the solar battery cell 2 and a shorter side having a width in which the probe pins 4 are arranged into a predetermined shape. Moreover, the holder 5 has such a structure that the plural probe pins 4 are buried therein with a predetermined arrangement forming the current measuring terminal 6 and the voltage measuring terminal 7 along a space between the upper and lower surfaces 5a and 5b.

### [Linear Arrangement]

As shown in Figs. 2 and 3, the current measuring terminal 6 and the voltage measuring terminal 7 are installed on the lower surface 5b of the holder 5 in parallel with each other. Moreover, both the current measuring terminal 6 and the voltage measuring terminal 7 are linearly formed along the longer side direction of the lower surface 5b of the holder 5. Each of the probe pins 4 forming the current measuring terminal 6 and the voltage measuring terminal 7 has a contact portion 4b formed into a column shape having a diameter of 3.5 mm, with a space S1 to the adjacent contact portion 4b being set to 0.1 mm that is shorter than a space between generally-used finger electrodes.

The current measuring terminal 6 has a structure in which the space S1 between the contact portions 4b to be made in contact with the surface electrode 3 of the solar battery cell 2 is set to 0.1 mm; therefore, for example, in a solar battery cell 2 having a so-called busbarless structure in which only a plurality of finger electrodes 3a that are in parallel with one another with a predetermined interval are formed as the surface electrode 3, the contact portions 4b can be arranged with a shorter space than the generally-used space of the finger electrodes 3a (for example, 1.0 to 2.0 mm). Thus, in accordance with the solar battery measurement jig 1, even in the case when there are deviations in the spaces between the finger electrodes 3a depending on solar battery cells 2, it is possible to suitably deal with the spaces of all the finger electrodes 3a.

In this manner, in comparison with a measurement jig in which probe electrodes in one row are compatibly used as the current measuring terminal and the voltage measuring terminal, by forming the current measuring terminal 6 and the voltage measuring terminal 7, the solar battery measurement jig 1 makes it possible to increase the number of probe pins to be made in contact with the finger electrodes 3a, and in particular, in accordance with the solar battery measurement jig 1, the contact portions 4b of the probe pins 4 can be made in contact with all the finger electrodes 3a. Moreover, by forming the current measuring terminal 6 and the voltage measuring terminal 7 in parallel with each other, without widening the space between the upper and lower surfaces 5a and 5b of the holder 5, it becomes possible to suppress a loss of shadow caused by the holder 5 to a low level and also to prevent an output reduction, upon measuring electrical characteristics.

Moreover, as shown in Fig. 3, in the current measuring terminal 6 and the voltage measuring terminal 7, the mutual probe pins 4 are partially overlapped with each other in the arrangement direction. That is, the current measuring terminal 6 and the voltage measuring terminal 7 are configured such that the mutual probe pins 4 are arranged in parallel with each other along the longer side direction of the lower surface 5b of the holder 5, and when viewed from the width direction of the lower surface 5b of the holder 5 that is orthogonal to the arrangement direction, the center of each contact portion 4b of the probe pins 4 on one side is located between the probe pins 4 on the other side, with a space S2 between the mutual contact portions 4b being set to, for example, 0.1 mm, so as to be very close to each other.

With this arrangement, since the current measuring terminal 6 and the voltage measuring terminal 7 are configured such that the contact portions 4b of the mutual probe pins 4 are partially overlapped with each other when viewed in the arrangement direction so as to be arranged with a narrowed space in the width direction of the lower surface 5b of the holder 5. Therefore, the holder 5 is designed such that the width of the holder 5 that is made in contact with the surface of the solar battery cell 2 is narrowed, thereby making it possible to prevent an output reduction due to a loss of shadow.

When used for measuring current and voltage characteristics of, for example, a solar battery cell of 6 inches, the solar battery measurement jig 1 is designed such that the longer side of each of the upper and lower surfaces 5a and 5b of the holder 5 is set to 156 mm corresponding to the length of one side of the solar battery cell 2, and 43 pieces of the probe pins 4 forming the current measuring terminal 6 are linearly arranged along the longer side direction of the holder 5, with an interval of 0.1 mm, and in parallel with these so as to be adjacent thereto, 42 pieces of the probe pins 4 forming the voltage measuring terminal 7 are arranged, with an interval of 0.1 mm in the same manner.

### [Zig-Zag Arrangement]

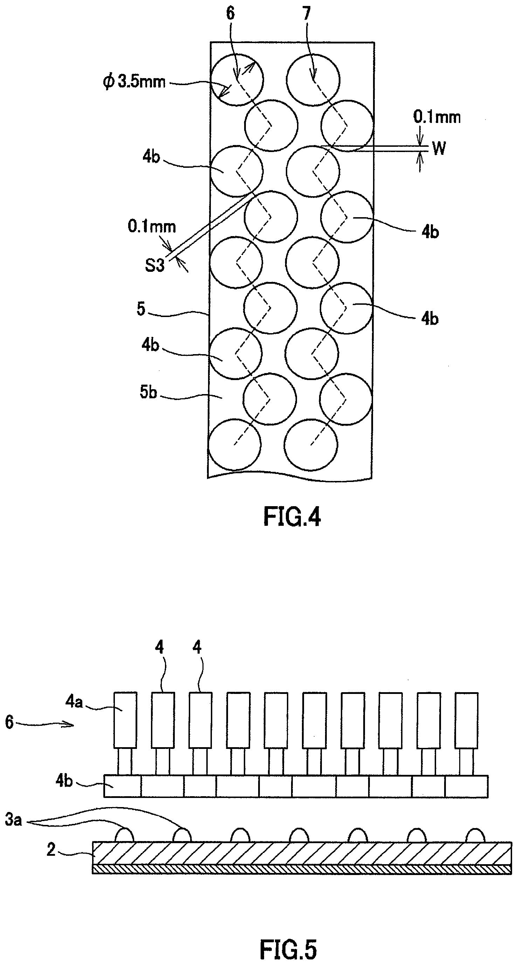

Moreover, the solar battery measurement jig 1 may be designed such that as shown in Fig. 4, both the current measuring terminal 6 and the voltage measuring terminal 7 are formed in a zig-zag pattern along the longer side direction of the lower surface 5b of the holder 5. In the current measuring terminal 6 and the voltage measuring terminal 7, by forming the probe pins 4 of the respective rows in a zig-zag pattern, the contact portions 4b of the respectively adjacent probe pins 4 can be partially overlapped with each other in a direction orthogonal to the arrangement direction. That is, the current measuring terminal 6 is arranged such that the probe pins 4 are arranged in a zig-zag pattern along the longer side direction of the lower surface 5b of the holder 5, and such that when viewed from the width direction of the lower surface 5b of the holder 5 that is orthogonal to the arrangement direction, the contact portions 4b of the adjacent probe pins 4 are partially overlapped with each other. The voltage measuring terminal 7 is also configured in the same manner. Additionally, a space S3 between the contact portions 4b of the adjacent probe pins 4 is set to, for example, 0.1 mm, so as to be very close to each other.

In this manner, in the current measuring terminal 6 and the voltage measuring terminal 7, by allowing the contact portions 4b of the mutually adjacent probe pins 4 to be partially overlapped with each other in a direction orthogonal to the arrangement direction, the space is removed along the arrangement direction. Therefore, in accordance with the solar battery measurement jig 1, even in the case of measurements for electrical characteristics by using a solar battery cell 2 having a so-called busbarless structure in which, as shown in Fig. 5, only a plurality of finger electrodes 3a that are in parallel with one another with a predetermined interval are formed as the surface electrode 3, the current measuring terminal 6 and the voltage measuring terminal 7 can be made in contact with all the finger electrodes 3a regardless of spaces between the finger electrodes 3a.

Moreover, in the current measuring terminal 6 and the voltage measuring terminal 7, by adjusting an overlapped width W between the contact portions 4b of the mutually adjacent probe pins 4, the width of the holder 5 that is made in contact with the surface of the solar battery cell 2 is narrowed, thereby making it possible to prevent an output reduction due to a loss of shadow. That is, in the structure in which the probe pins 4 are arranged in a zig-zag pattern, in order to increase the width to be overlapped with each other in a direction orthogonal to the arrangement direction, the adjacent probe pins 4 need to be shifted in the width direction of the upper and lower surfaces 5a and 5b of the holder 5, and also to be made closer to each other in the arrangement direction.

However, in the case when the probe pins 4 are shifted in the width direction of the upper and lower surfaces 5a and 5b of the holder 5, the width of the holder 5 is widened correspondingly, with the result that the area of the holder 5 covering the surface of the solar battery cell 2 increases, causing an output reduction due to a loss of shadow.

On the other hand, when the current measuring terminal 6 and the voltage measuring terminal 7 are designed such that the contact portions 4b of the mutually adjacent probe pins 4 are overlapped with each other even at partial portions in a direction orthogonal to the arrangement direction, the resulting structure can suitably deal with spaces of all kinds of finger electrodes 3 a.

Therefore, in the case when the current measuring terminal 6 and the voltage measuring terminal 7 are designed such that the overlapped width W between the contact portions 4b of the mutually adjacent probe pins 4 is set to a predetermined width or less, that is, for example, 0.1 mm or less, the contact portions 4b can be made in contact with the finger electrodes 3a in a manner so as to deal with spaces of all kinds of finger electrodes 3a, and the width of the holder 5 can be narrowed, thereby preventing an output reduction due to a loss of shadow.

When used for measuring current and voltage characteristics of, for example, a solar battery cell of 6 inches, the solar battery measurement jig 1 is designed such that the longer side of each of the upper and lower faces 5a and 5b of the holder 5 is set to 156 mm corresponding to the length of one side of the solar battery cell 2 and 45 pieces of the probe pins 4 forming the current measuring terminal 6 are arranged in a zig-zag pattern along the longer side direction of the holder 5, with an interval of 0.1 mm and with each of overlapping width W of 0.1mm placed in a direction orthogonal to the arrangement direction, and adjacent to these, 44 pieces of the probe pins 4 forming the voltage measuring terminal 7 are arranged in parallel with these so as to be adjacent thereto, with an interval of 0.1 mm in the same manner.

### [Rocking Means]

Additionally, in the solar battery measurement jig 1, a cylinder jig, not shown, is connected to the holder 5, and by moving the respective probe pins 4 upward and downward together with the holder 5 in accordance with operations of this cylinder jig, or by manual operations, or the like, the respective probe pins 4 are pressed vertically onto the surface electrode 3 of the solar battery cell 2.

### [Others]

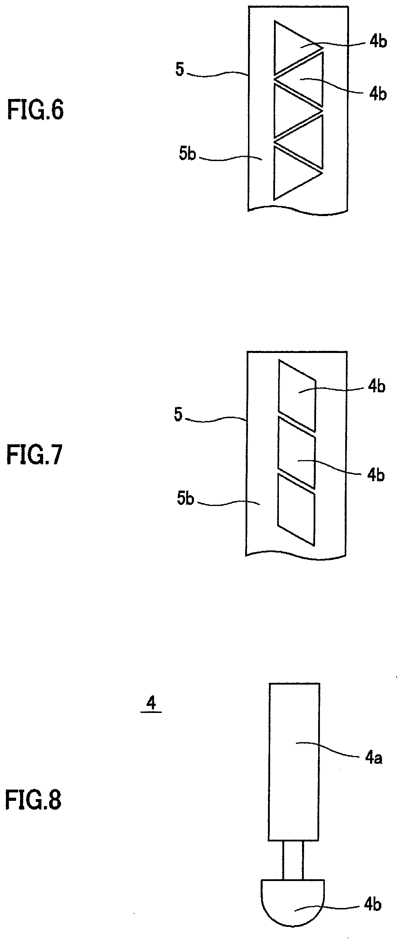

In addition to a round shape in the tip shape of each of the contact portions 4b of the probe pins 4, as shown in Figs. 6 and 7, the tip shape may be formed into any shapes, such as a triangular shape, a rhombus shape, or the like. Moreover, as shown in Fig. 8, the contact portion 4b of each probe pin 4 may be formed into a semi-spherical shape at its tip.

### [Solar Battery Cell 2]

The following description will discuss the solar battery cell 2 on which measurements of electrical characteristics are carried out by the solar battery measurement jig 1. The solar battery cell 2 has a structure in which bus bar electrodes are not formed, and tab wires 11 forming inter connectors are directly bonded to finger electrodes 3a so as to intersect therewith, and the solar battery measurement jig 1 is desirably used for measuring the solar battery cell 2 having such a busbarless structure.

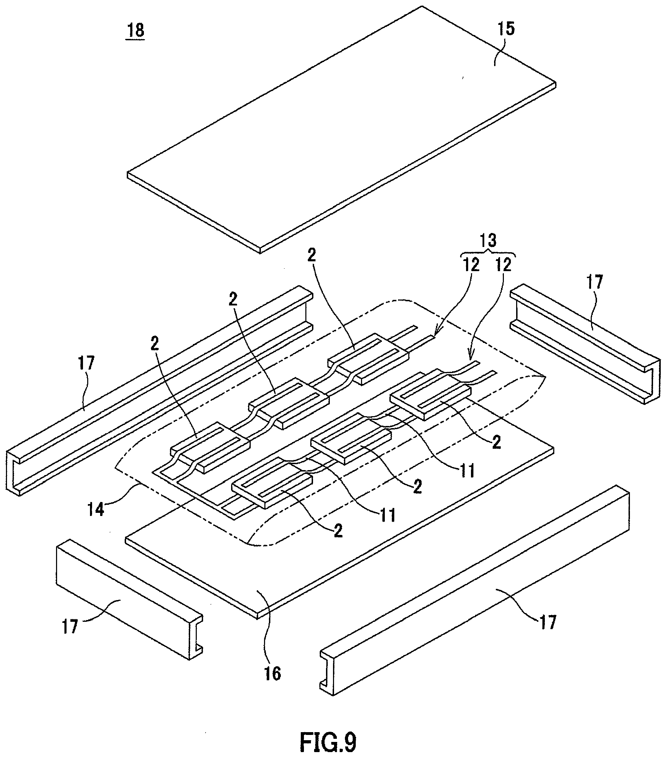

As shown in Fig. 9, the solar battery cells 2 having the busbarless structure are connected to one after another by the tab wires 11 serving as interconnectors in series with, or in parallel with one another so that each of strings 12 is formed. A plurality of these strings 12 are arranged so that a matrix 13 is formed, and this matrix 13 is sandwiched by sheets 14 of a sealing adhesive agent, and laminated in a batch process together with a surface cover 15 formed on a light-receiving side and a back sheet 16 formed on a rear-surface side, and lastly, a metal frame 17 such as aluminum is attached on the periphery thereof so that a solar battery cell module 18 is formed.

As the sealing adhesive agent, for example, a translucent sealing material, such as ethylene-vinyl acetate copolymer resin (EVA) or the like, is used. Moreover, as the surface cover 15, for example, a translucent material, such as glass, a translucent plastic material, or the like, is used. Furthermore, as the back sheet 16, a laminate or the like in which glass or an aluminum foil is sandwiched by resin films is used.

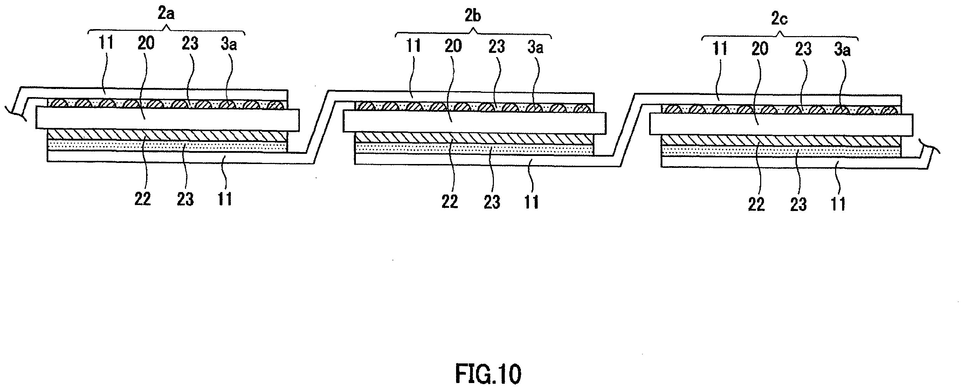

As shown in Fig. 10, each of the solar battery cells 2 of the solar battery cell module 18 is provided with a photoelectric conversion element 20. As the photoelectric conversion element 20, various kinds of photoelectric conversion elements 20 are used for forming a crystal silicon-based solar battery using a single-crystal-type silicon photoelectric conversion element, or a polycrystal-type photoelectric conversion element, and a thin-film silicon-based solar cell using a photoelectric conversion element in which cells made of amorphous silicon and cells made of fine crystal silicon or amorphous silicon germanium are laminated with one another.

Moreover, the photoelectric conversion element 20 is provided with finger electrodes 3a for collecting electricity generated the inside thereof that are formed on the light-receiving surface side. The finger electrodes 3a are formed by processes in which, after an Ag paste has been applied onto the surface forming a light-receiving surface of the solar battery cell 2 by a screen printing process or the like, the resulting surface is subjected to a baking process. Moreover, the finger electrodes 3a have a structure in which over the entire surface of the light-receiving surface, a plurality of lines, each having a width of, for example, about 50 to 200 µm, are formed virtually in parallel with one another with a predetermined interval, for example, 2 mm, and the tab wires 11 are connected to all the finger electrodes 3a so as to intersect therewith, by a conductive adhesive film 23.

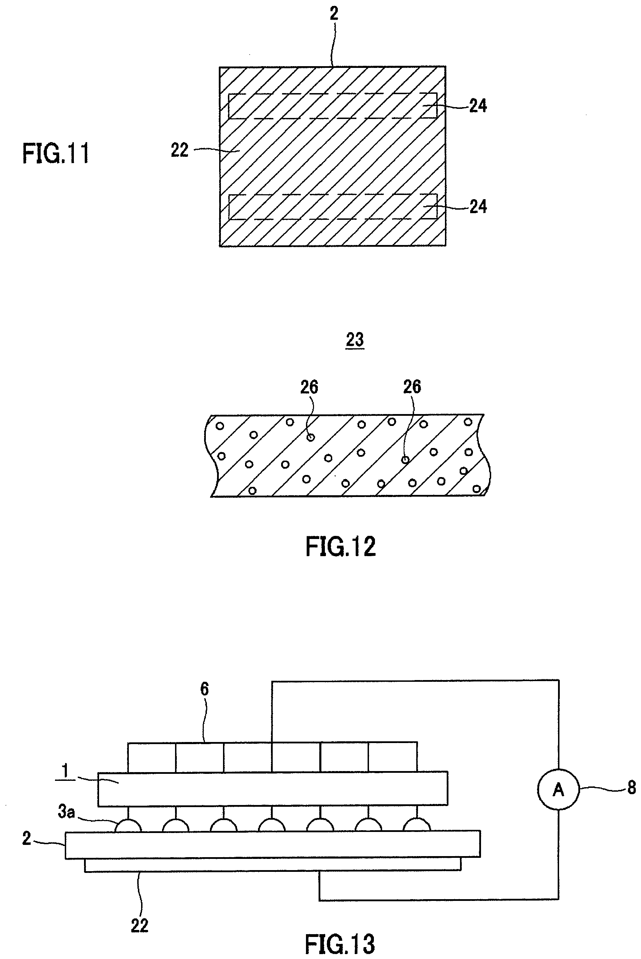

Moreover, the photoelectric conversion element 20 has a structure in which a rear surface electrode 22 made of aluminum or silver is formed on a rear surface side opposite to the light-receiving surface. The rear surface electrode 22 has a structure in which electrodes made of aluminum or silver are formed on the rear surface of the solar battery cell 2 by using, for example, a screen printing method, a sputtering method or the like. As shown in Fig. 11, the rear surface electrode 22 is provided with tab wire connection portions 24 to which the tab wires 11 are connected, with the conductive adhesive film 23 to be described later interposed therebetween.

Furthermore, the solar battery cell 2 is designed such that the respective finger electrodes 3a formed on the surface and the rear surface electrode 22 of the adjacent solar battery cell 2 are electrically connected by the tab wires 11 to each other so that each of strings 12 that are connected in series with one another is formed. The tab wires 11, the finger electrodes 3a and the rear surface electrode 22 are connected to one another by conductive adhesive films 23.

As shown in Fig. 10, each of the tab wires 11 is composed of an elongated conductive substrate that electrically connects the adjacent solar battery cells 2a, 2b and 2c to one another, with a thickness of, for example, 50 to 300 µm, and made of a ribbon-shaped copper foil having virtually the same width as that of the conductive adhesive film 23 to be described later, which is subjected to gold plating, silver plating, tin plating, solder plating or the like thereon, if necessary.

### [Adhesive Film]

As shown in Fig. 12, the conductive adhesive film 23 is a thermosetting binder resin layer that contains conductive particles 26 at a high density.

As the conductive particles 26 for use in the conductive adhesive film 23, although not particularly limited, metal particles of nickel, gold, silver, copper or the like, or resin particles that gold plating is applied, or those resin particles to which gold plating is applied, with an insulation coating process being carried out on the outermost layer of each particle, may be used.

As the composition of the binder resin layer of the conductive adhesive film 23, although not particularly limited, preferably, a film-forming resin, a liquid-state epoxy resin, a potential curing agent and a silane coupling agent are contained therein.

Moreover, the conductive adhesive film 23 is formed into predetermined lengths as two films for surface electrodes and two films for rear-surface electrodes, and these are temporarily pasted onto predetermined positions of the surface and rear-surface of the solar battery cells 2. In this case, the conductive adhesive film 23 is temporarily pasted thereon so as to be virtually orthogonal to the plural finger electrodes 3a formed on the surface of the solar battery cell 2 virtually in parallel therewith.

In the same manner, the tab wire 11 that is cut into a predetermined length is superposed and disposed on the conductive adhesive film 23. Thereafter, the conductive adhesive film 23 is heated and pressed from the tab wire 11 formed thereon by a heating bonder at predetermined temperature and pressure for a predetermined period of time so that while the binder resin is cured, the conductive particles 26 are sandwiched between the tab wire 11 and the finger electrodes 3a or the rear-surface electrode 22. Thus, the conductive adhesive film 23 allows the tab wire 11 to be bonded onto the respective electrodes, and connected thereto so as to secure conduction.

Additionally, the above-mentioned embodiment has explained a structure using the conductive adhesive film 23; however, not limited to the film-shaped conductive adhesive agent, the present invention may use a paste-state conductive adhesive agent, an insulation adhesive film containing no conductive particles, or an insulation adhesive paste.

### [Measuring Method]

The following description will discuss measuring processes of electrical characteristics of the solar battery cell 2 by using the solar battery measurement jig 1.

The measurements of electrical characteristics of the solar battery cell 2 the solar battery measurement jig 1 are carried out at a stage in which the finger electrodes 3a and the rear-surface electrode 22 have been formed on the photoelectric conversion element 20. More specifically, the solar battery cell 2 is mounted on a mounting platform 30, with the light-receiving surface with the finger electrodes 3a formed thereon facing up. The mounting platform 30 is formed by carrying out, for example, an Au plating process on a Cu plate so that conduction is secured to the rear-surface electrodes 22 of the solar battery cell 2.

Next, as shown in Fig. 1, the solar battery measurement jig 1 is disposed in a manner so as to allow the respective probe pins 4 of the current measuring terminal 6 and the voltage measuring terminal 7 to be made orthogonal to all the finger electrodes 3a, and the current measuring terminal 6 and the voltage measuring terminal 7 are pressed with a predetermined load by a load means, not shown. At this time, since the solar battery measurement jig 1 is provided with the current measuring terminal 6 and the voltage measuring terminal 7, the contact portions 4b of the respective probe pins 4 are made in contact with the finger electrodes 3a. Therefore, the current measuring terminal 6 can be made in contact with all the finger electrodes so that the current characteristics can be measured with higher precision.

In this case, the total load given to the current measuring terminal 6 and the voltage measuring terminal 7 by the load means is preferably set in a range from 500 g to 3000 g. When the total load is less than 500 g, the contact between the contact portions 4b of the probe pins 4 and the finger electrodes 3a becomes insufficient, causing a risk of output reduction, and when the entire load exceeds 3000 g, the finger electrodes 3a and the solar battery cell 2 may be damaged by the probe pins 4.

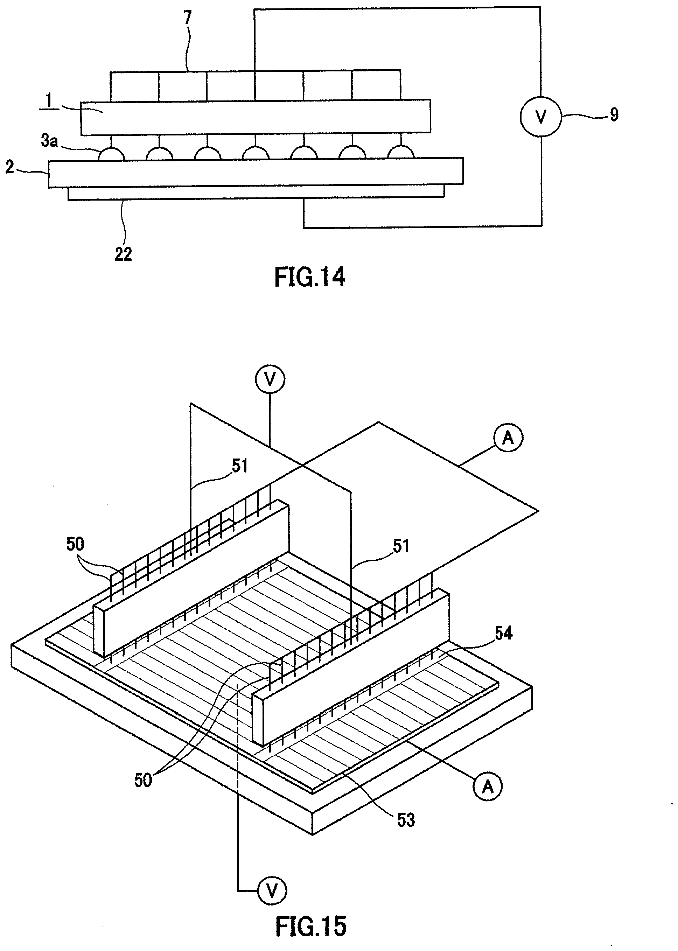

A circuit configuration as shown in Figs. 13 and 14 is provided by making the solar battery measurement jig 1 in contact with the cell surface, and in this state, by irradiating the cell surface with pseudo-solar light, the electrical characteristics of the solar battery cell 2 can be measured by using a so-called four terminal method.

In this case, the solar battery measurement jig 1 is designed so that the current measuring terminal 6 and the voltage measuring terminal 7 are formed in parallel with each other; thus, without widening the width between the upper and lower surfaces 5a and 5b of the holder 5, it is possible to suppress a loss of shadow by the holder 5 upon measuring the electrical characteristics, and consequently to prevent an output reduction.

Moreover, in the case when the solar battery measurement jig 1 in which the probe pins 4 of the respective rows of the current measuring terminal 6 and the voltage measuring terminal 7 are arranged in a zig-zag pattern is used, by allowing the contact portions 4b of the mutually adjacent probe pins 4 to be partially overlapped with each other in a direction orthogonal to the arrangement direction, it is possible to eliminate spaces over the arrangement direction. Therefore, regardless of the spaces of the finger electrodes 3a, the current measuring terminal 6 can be made in contact with all the finger electrodes 3a so that the current characteristic can be measured with higher precision.

In the solar battery measurement jig 1 having the current measuring terminal 6 and the voltage measuring terminal 7 with such a zig-zag pattern, by setting the overlapped width of the contact portions 4b of the mutually adjacent probe pins 4 to a predetermined width or less, for example, to 0.1 mm or less, the contact portions 4b can be made in contact with the finger electrodes 3a in a manner so as to deal with all the spaces of the finger electrodes 3a, and the width of the holder 5 can be narrowed so that an output reduction by a loss of shadow can be prevented, thereby making it possible to carry out measurements of the current and voltage characteristics with higher precision.

In addition to the solar battery cell 2 having the above-mentioned so-called busbarless structure, the solar battery measurement jig 1 that the present invention is applied can also be used for measuring the electrical characteristics of a solar battery cell with bus bar electrodes formed in a direction orthogonal to the finger electrodes 3a. In this case, the solar battery measurements jig 1 makes the current measuring terminal 6 and the voltage measuring terminal 7 in contact with the bus bar electrodes; however, as described above, even when they are made in contact with the finger electrodes 3a, measurements can be carried out without any problems.

### EXAMPLES

The following description will discuss examples in which by using the solar battery cell measurement jig 1 that the present invention is applied, photoelectric conversion efficiencies of a solar battery cell 2 having a busbarless structure and a solar battery cell provided with bus bar electrodes are respectively measured.

The solar battery cell 2 having a busbarless structure used in this example has a structure in which a single-crystal silicon photoelectric conversion element of 6 inches is used, with the plural finger electrodes 3a being formed on the light-receiving surface side with an interval of 2.4 mm, and with an Ag electrode being formed over the entire surface on the rear-surface side. Moreover, the solar battery cell with the bus bar electrodes formed thereon has a structure of the solar battery cell 2 having a busbarless structure and bus bar electrodes that are orthogonal to the finger electrodes 3a are further formed thereon.

In example 1, by using the solar battery measurement jig 1 (see Fig. 3) on which the current measuring terminal 6 and the voltage measuring terminal 7 were formed by linearly forming two rows of probe pins 4, the photoelectric conversion efficiency of the solar battery cell 2 of the busbarless structure was measured. The contact portions 4b of the respective probe pins 4 of the current measuring terminal 6 and the voltage measuring terminal 7 are arranged with a space S 1 between the contact portions 4b of the adjacent probe pins 4 being set to 0.1 mm. Moreover, the total load applied to the current measuring terminal 6 and the voltage measuring terminal 7 was set to 850 g.

In example 2, by using the solar battery measurement jig 1 (see Fig. 4) on which the current measuring terminal 6 and the voltage measuring terminal 7 were formed by arranging two rows of the probe pins 4 in a zig-zag pattern, the photoelectric conversion efficiency of the solar battery cell 2 having a busbarless structure was measured. The contact portion 4b of each of the probe pins 4 of the current measuring terminal 6 and the voltage measuring terminal 7 was overlapped with the contact portion 4b of each of the adjacent probe pins 4 with a width W of 0.1 mm in a direction orthogonal to the arrangement direction. Moreover, the total load applied to the current measuring terminal 6 and the voltage measuring terminal 7 was set to 500 g.

In example 3, the same structure as that of example 2 was used except that the total load applied to the current measuring terminal 6 and the voltage measuring terminal 7 was set to 850 g.

In example 4, the same structure as that of example 2 was used except that the total load applied to the current measuring terminal 6 and the voltage measuring terminal 7 was set to 2975 g.

In example 5, the same structure as that of example 1 was used except that with respect to a solar battery cell on which busbar electrodes are formed, the current measuring terminal 6 and the voltage measuring terminal 7 are made in contact with the busbar electrodes.

In comparative example 1, the same structure as that of example 2 was used except that the total load applied to the current measuring terminal 6 and the voltage measuring terminal 7 was set to 400 g.

In comparative example 2, by using a solar battery measurement jig in which bar electrodes having a rectangular plate shape were used as the measuring terminal, the photoelectric conversion efficiency of the solar battery cell 2 having a busbarless structure was measured. In comparative example 2, measurements were carried out, with the bar electrodes being disposed so as to intersect with all the finger electrodes 3a of the solar battery cell 2.

In comparative example 3, by using a measurement jig in which probe pins in only one row were arranged, the photoelectric conversion efficiency of the solar battery cell 2 having a busbarless structure was measured (see Fig. 21). The total load applied to the current measuring terminal 6 and the voltage measuring terminal 7 was set to 850 g.

With respect to the above-mentioned examples and comparative examples, in the measurements of the photoelectric conversion efficiency, the current measuring terminal 6 and the voltage measuring terminal 7 were made in contact with the finger electrodes 3a or the bus bar electrodes so that an I-V characteristic was found, and based on this, the maximum power Pmax was found. Moreover, measurements of the photoelectric conversion efficiency were carried out by using a solar simulator (PVS1116i, made by Nisshinbo Mechatronics Inc.), under the conditions (JIS C8913) of an illuminance of 1000 W/m², a temperature of 25°C and a spectrum of AM 1.5G. Moreover, in each of the examples and comparative examples, measurements were carried out 5 times, and the average value of the maximum powers Pmax and the standard deviation Pmaxσ were found so that examinations were carried out on the degree to which deviations occurred for each of the measurements.

The evaluation criteria of the photoelectric conversion efficiency are explained as follows.
⊚: The average maximum power Pmax is 3.80 (W) or more, and the standard deviation Pmaxσ is 0.018 or less.
○: The average maximum power Pmax is less than 3.80 (W), and the standard deviation Pmaxσ is 0.018 or less.
Δ: The average maximum power Pmax is less than 3.80 (W), and the standard deviation Pmaxσ is greater than 0.018 and smaller than 0.03 or less.
× : The average maximum power Pmax is less than 3.80 (W), and the standard deviation Pmaxσ is 0.03 or more.

The measurement results are shown in Table 1.

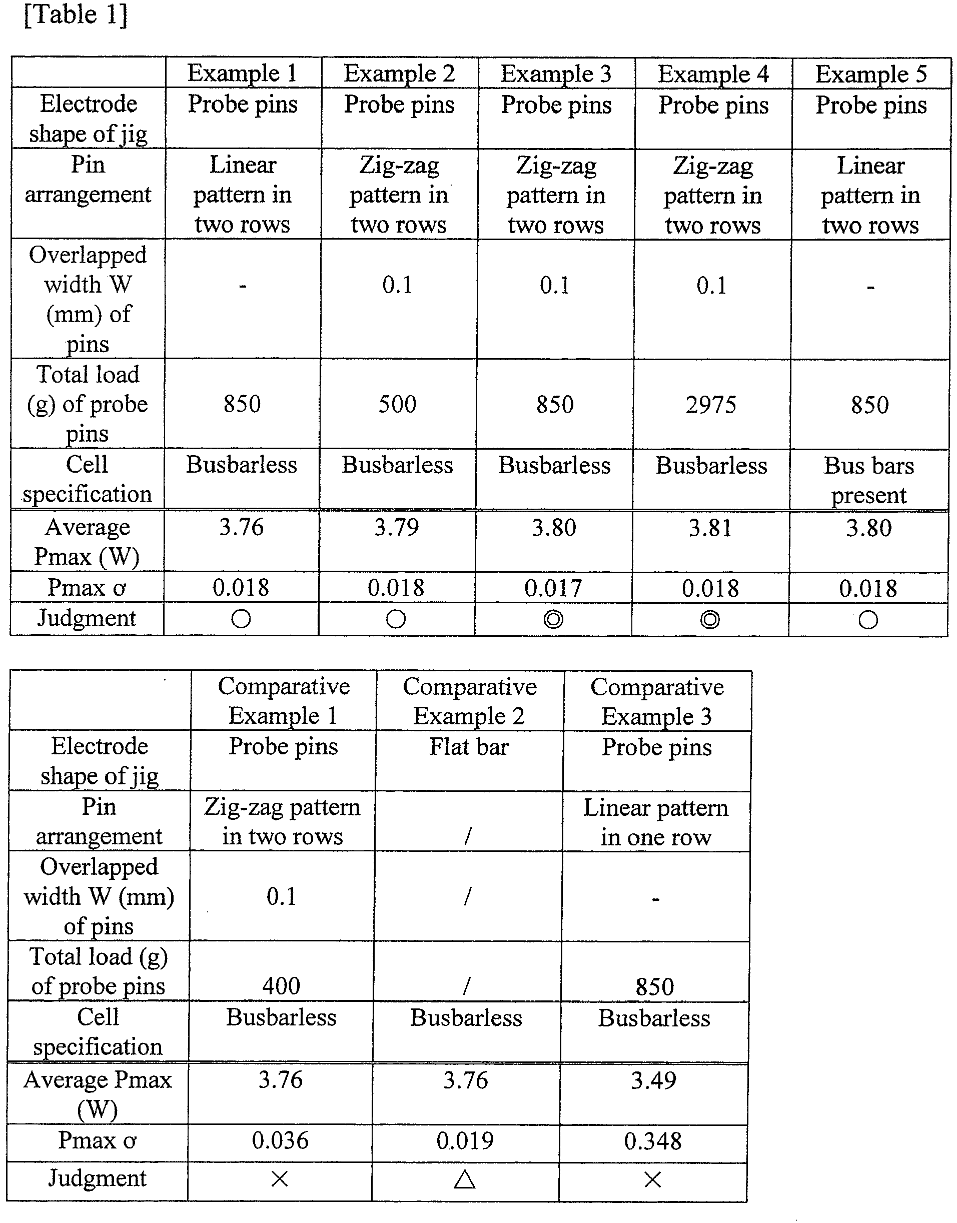

As shown in Table 1, in examples 1 to 4 where the electrical characteristics of the solar battery cell 2 having a busbarless structure were measured, the average maximum power Pmax thereof had virtually the same value as that of the solar battery cell relating to example 5 on which the bus bar electrodes were formed, and the standard deviation Pmaxσ was 0.018 or less indicating that deviations in measurements were small; therefore, it is found that these can carry out measurements accurately in a stable manner also on the solar battery cell having a busbarless structure.

In comparative example 1, since the total load applied to the current measuring terminal 6 and the voltage measuring terminal 7 is as small as 400 g to cause the contact between the finger electrodes 3a and the contact portions 4b of the probe pins 4 to become insufficient, the standard deviation Pmaxσ is increased to 0.036 indicating that deviations in measurements become large.

In comparative example 2, since the bar electrodes are used, the standard deviation Pmaxσ is increased to 0.019 indicating that deviations in measurements become slightly large because of deviations in heights of the finger electrodes 3a and deviations in the degree of flatness of the contact surface onto the finger electrodes 3a of the bar electrodes.

In comparative example 3, since the probe pins in one row are linearly formed, installation spaces of the probe pins and formation spaces of the finger electrodes are not coincident with each other, and since there are also deviations in contact positions between the probe pins and the finger electrodes for each of the measurements, the contact between the probe pins and the finger electrodes becomes insufficient, failing to accurately carry out the current and voltage measurements, and the standard deviation Pmaxσ is also increased to 0.348 with the result that deviations in measurements become large.

Moreover, when example 1 and examples 2 to 4 are compared with one another, it is found that in the case of the measurement jig in which by arranging two rows of the probe pins 4 in a zig-zag pattern, the current measuring terminal 6 and the voltage measuring terminal 7 are formed, the measurements of electrical characteristics can be carried out with higher precision in comparison with the measurement jig in which by linearly arranging two rows of the probe pins 4, the current measuring terminal 6 and the voltage measuring terminal 7 are formed. This effect can be obtained because by arranging two rows of the probe pins 4 in a zig-zag pattern, the contact portions 4b can be partially overlapped with one another in an arrangement direction of the plural finger electrodes 3a, that is, in a direction orthogonal to the arrangement direction of the probe pins 4. Thus, spaces between the probe pins 4 are eliminated over a direction in which the plural finger electrodes 3a are arranged (see Fig. 5); thus, regardless of the spaces of the finger electrodes 3a, the contact portions 4b can be made in contact with all the finger electrodes 3a so that electrical characteristics can be measured with higher precision.

### [Second Solar Battery Measurement Jig]

In the above description, explanation has been given on the solar battery measurement jig 1 having the current measuring terminal 6 and the voltage measuring terminal 7 configured by arranging the plural probe pins 4 in a linear form and in a zig-zag pattern respectively; however, the solar battery measurement jig that the present invention is applied may have the following configuration. Additionally, in the following explanation, those members that have the same structures as those of the aforementioned solar battery measurement jig 1, are indicated by the same reference numerals, and the description thereof will be omitted.

As shown in Fig. 15, this solar battery cell measurement jig 40 has a plurality of probe pins 4 that are made in contact with finger electrodes 3a formed on the surface of the solar battery cell 2, and form a measuring terminal 41 for use in measuring electrical characteristics of the solar battery cell 2, and a holder 5 for holding the probe pins 4.

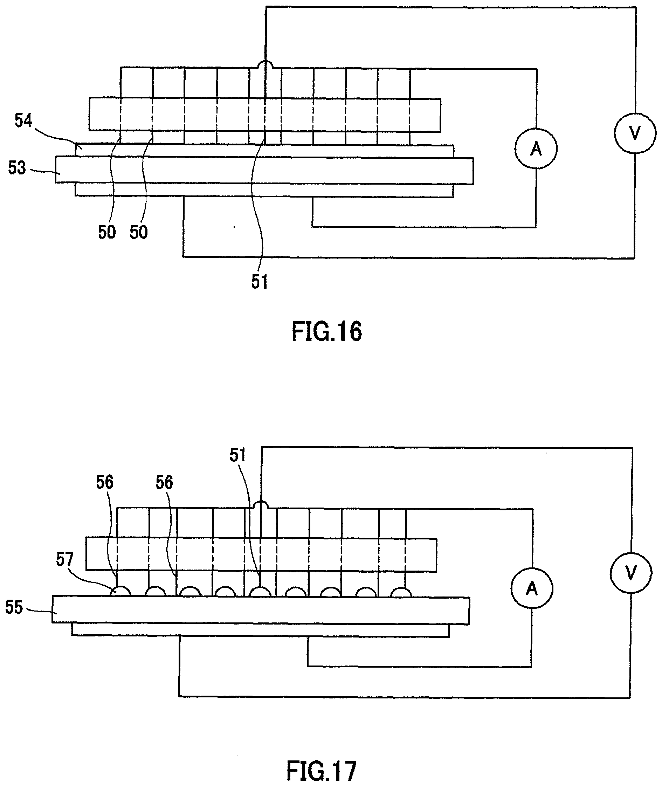

As shown in Fig. 16, the plural probe pins 4 are arranged in a zig-zag pattern so as to be partially overlapped with one another in an arrangement direction so that the measuring terminal 41 in one row is formed. The probe pins 4 are held by the holder 5.

The holder 5 is formed into a rectangular plate shape by using a conductive material, for example, such as metal or the like. Moreover, the holder 5 has a structure in which the plural probe pins 4 are arranged in a zig-zag pattern between the upper and lower surfaces 5a and 5b, and a single measuring terminal 41 in one row is thus formed.

In this case, the plural probe pins 4 are designed so that the mutually adjacent probe pins are partially overlapped with one another in an arrangement direction, that is, in a longitudinal direction of the holder 5. The solar battery measuring jig 40 is allowed to have the structure in which the probe pins are arranged in a zig-zag pattern to form the measuring terminal 41 in one row so that it is possible to reduce a loss of shadow that causes an output value reduction due to a shadow of the holder 5 formed on the light-receiving surface, upon measuring the electrical characteristics of the solar battery cell 2.

Moreover, as shown in Fig. 17, the plural probe pins 4 have such a structure as to form a space W between the adjacent probe pins 4 in the arrangement direction, which is shorter than a generally-used space (for example, 1.0 to 2.0 mm) of the finger electrodes 3a in a solar battery cell 2 having a busbarless structure; thus, even when there are deviations in the spaces of the finger electrodes 3a, it is possible to suitably deal with the spaces of all the finger electrodes 3a.

Moreover, with respect to the plural probe pins 4, as shown in Fig. 16, the mutually adjacent probe pins 4 may be partially overlapped with one another in the arrangement direction, that is, in a width direction orthogonal to the longitudinal direction of the holder 5. In the solar battery measurement jig 40, by allowing the mutually adjacent probe pins 4 to be partially overlapped with one another in the direction orthogonal to the arrangement direction, spaces are removed over the arrangement direction. Therefore, in accordance with this solar battery measurement jig 40, upon measuring the electrical characteristics of the solar battery cell 2 having a busbarless structure, the probe pins 4 can be made in contact with all the finger electrodes 3a regardless of spaces of the finger electrodes 3a.

Moreover, the holder 5 has its one end in a longitudinal direction connected to a current measuring terminal 42 and a voltage measuring terminal 43 that are respectively connected to an I-V measuring device, not shown. Thus, in the solar battery measurement jig 40, the probe pins 4 and the holder 5 are allowed to form one measuring terminal, and by using the I-V measuring device connected thereto through the current measuring terminal 42 and the voltage measuring terminal 43, it is possible to measure I-V characteristics (current and voltage values), Isc (short-circuit current), Voc (open voltage), Pm (maximum output), Ipm (maximum output operational current), Vpm (maximum output operational voltage), Eff (conversion efficiency), FF (fill factor), MTemp (measuring temperature), etc.

### [Exemplified Dimension]

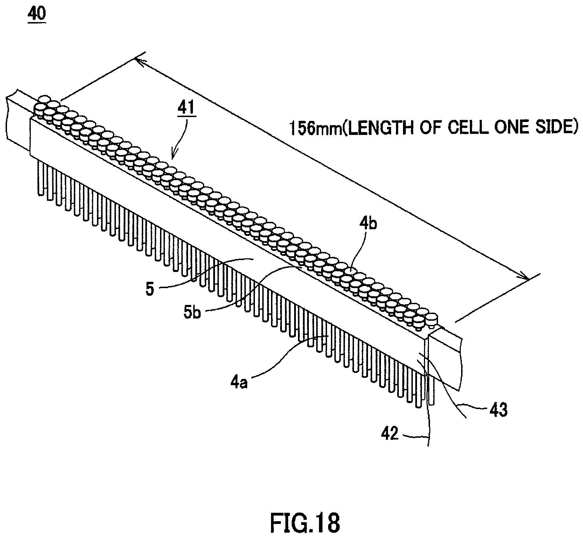

As shown in Figs. 16 and 18, when used for measuring current and voltage characteristics of a solar battery cell 2 having a size of, for example, 6 inches, the solar battery measurement jig 40 has a structure in which the longer side of the upper and lower surfaces 5a and 5b of the holder 5 is set to 156 mm corresponding to the length of one side of the solar battery cell 2, and 111 pieces of the probe pins 4 with contact portions 4b having a diameter of 1.5 mm are arranged in a zig-zag pattern along the longer side direction of the holder 5. Moreover, the solar battery measurement jig 40 is designed such that supposing that a space S3 between the mutually adjacent probe pins 4 and an overlapped width W between the mutually adjacent probe pins 4 in a direction orthogonal to the arrangement direction are respectively set to 0.1 mm, the width of the holder can be narrowed to 2.5 mm.

Additionally, in the same manner as in the aforementioned solar battery measurement jig 1, in addition to the solar battery cell 2 having a busblarless structure, the solar battery measurement jig 40 may also be used for the current and voltage measurements of the solar battery cell in which the bus bar electrodes are installed. Moreover, in the same manner as in the aforementioned solar battery measurement jig 1, the solar battery measurement jig 40 is preferably designed to apply a load to the measuring terminal 41 by a load means, with the total load being set in a range from 430 g to less than 3000 g relative to the measuring terminal 41.

Moreover, in the same manner as in the aforementioned solar battery measurement jig 1, the solar battery measurement jig 40 may also be provided with a rocking means that presses the respective probe pins 4 vertically onto the surface electrode 3 of the solar battery cell 2. In addition to a round shape in the tip shape of each of the contact portions 4b of the probe pins 4, the tip shape may be formed into any shapes, such as a triangular shape, a rhombus shape, or the like (Figs. 6 and 7). Moreover, the contact portion 4b of each probe pin 4 may be formed into a semi-spherical shape at its tip (Fig. 8).

The following description will discuss example 2 of the present invention. In example 2, by using the solar battery measurement jig 40, photoelectric conversion efficiencies of the respective solar battery cell 2 having a busbarless structure and solar battery cell with bus bar electrodes formed thereon were measured.

In the solar battery cell 2 having a busbarless structure used in the present example, a single crystal silicon photoelectric conversion element having a size of 6 inches was used, with a plurality of finger electrodes 3a being formed on the light-receiving surface side with an interval of 2.4 mm, and with an Ag electrode being formed on the entire surface on the rear-surface side. Moreover, the solar battery cell with bus bar electrodes formed thereon has a structure in which in addition to the structure of the solar battery cell 2 having a busbarless structure, bus bar electrodes that are orthogonal to the finger electrodes 3a are formed.

In example 6, by using the solar battery measurement jig 40, the photoelectric conversion efficiency of the solar battery cell 2 having a busbarless structure was measured. The contact portions 4b of the respective probe pins 4 forming the measuring terminal were arranged, with a space S3 between the contact portions 4b of the adjacent probe pins 4 being set to 0.1 mm, and with an overlapped width W between the mutually adjacent contact portions 4b of the probe pins 4 in a direction orthogonal to the arrangement direction being also set to 0.1 mm. The total load relative to the solar battery measurement jig 40 was set to 710 g.

In example 7, the same conditions as those of example 6 were used except that the total load to the solar battery measurement jig 40 was set to 2240 g.

In example 8, the same conditions as those of example 6 were used except that with respect to the solar battery cell with bus bar electrodes formed therein, the probe pins 4 were made in contact with the bus bar electrodes.

In example 9, the same conditions as those of example 6 were used except that the total load to the solar battery measurement jig 40 was set to 430 g.

With respect to the above-mentioned examples and comparative examples, in the measurements of the photoelectric conversion efficiency, the probe pins 4 were made in contact with the finger electrodes 3a or the bus bar electrodes so that an I-V characteristic was found, and based on this, the maximum power Pmax was found. Moreover, measurements of the photoelectric conversion efficiency were carried out by using a solar simulator (PVS1116i, made by Nisshinbo Mechatronics Inc.), under the conditions (JIS C8913) of an illuminance of 1000 W/m², a temperature of 25°C and a spectrum of AM 1.5G. Moreover, in each of the examples and comparative examples, measurements were carried out 5 times, and the average value of the maximum powers Pmax and the FF (filling factor) were found.

The evaluation criteria of the photoelectric conversion efficiency are explained as follows.
⊚: The average maximum power Pmax is 3.85 (W) or more, and the FF is 0.77 or more.
○: The average maximum power Pmax is 3.80 (W) or more, and the FF is 0.77 or more.
Δ: The average maximum power Pmax is less than 3.80 (W).

Table 2 shows the results of measurements.

**[Table 2]**

| | Example 6 | Example 7 | Example 8 | Example 9 |
|---|---|---|---|---|
| Electrode shape of jig | Probe pins | Probe pins | Probe pins | Probe pins |
| Pin arrangement | Zig-zag pattern in one row | Zig-zag pattern in one row | Zig-zag pattern in one row | Zig-zag pattern in one row |
| Overlapped width W (mm) of pins | 0.1 | 0.1 | 0.1 | 0.1 |
| Total load (g) of probe pins | 710 | 2240 | 710 | 430 |
| Cell specification | Busbarless | Busbarless | Bus bars present | Busbarless |
| Average Pmax (W) | 3.80 | 3.88 | 3.89 | 3.76 |
| FF | 0.77 | 0.78 | 0.78 | 0.74 |
| Judgment | ○ | ⊚ | ⊚ | Δ |

As shown in Table 2, in examples 6, 7 and 9 where the electrical characteristics of the solar battery cell 2 having a busbarless structure were measured, the average maximum power Pmax and the FF (filling factor) thereof had virtually the same values as those of the solar battery cell relating to example 8 on which the bus bar electrodes are formed; therefore, it is found that also these can carry out measurements accurately in a stable manner on the solar battery cell having a busbarless structure.

Moreover, when examples 6, 7 and 9 are compared with each other, it is found that since, as the total load relative to the probe pins 4 becomes greater, the average maximum power Pmax is approximated by that of example 8, it is possible to carry out measurements of electrical characteristics with higher precision.

### Reference Signs List

1...solar battery measurement jig, 2...solar battery cell, 3...surface electrode, 3a...finger electrode, 4...probe pin, 5...4a...pin main body, 4b...contact portion, 5...holder, 6...current measuring terminal, 7...voltage measuring terminal, 8...ampere meter, 9...voltage meter, 11...tab wire, 12...string, 13...matrix, 14...sheet, 15...surface cover, 16...back sheet, 17...metal frame, 18...solar battery module, 20...photoelectric conversion element, 22...rear-surface electrode, 23...conductive adhesive film, 24...tab wire connection portion, 26... conductive particles, 40...solar battery measurement jig, 42...current measuring terminal, 43...voltage measuring terminal

## Claims

1. A solar battery measurement jig (1) comprising:
a plurality of probe pins (4) that are made in contact with a linear electrode formed on a surface of a solar battery cell (2);
a holder (5) for holding the probe pins (4);
a current measuring terminal (42) that is composed of the plural probe pins arranged thereon and is disposed on the linear electrode so as to measure a current characteristics of the solar battery cell; and
a voltage measuring terminal (43) that is composed of the plural probe pins arranged thereon and is disposed on the linear electrode so as to measure a voltage characteristics of the solar battery cell,
wherein
the current measuring terminal (42) and the voltage measuring terminal (43) are formed in parallel with each other;
each of the current measuring terminal (42) and the voltage measuring terminal (43) is composed of the probe pins (4) that are linearly arranged; and wherein
each of the current measuring terminal (42) and the voltage measuring terminal (43) is composed of the probe pins (4) that are partially overlapped with each other in the arrangement direction.

2. A solar battery measurement jig (1) comprising:
a plurality of probe pins (4) that are made in contact with a linear electrode formed on a surface of a solar battery cell (2);
a holder (5) for holding the probe pins (4);
a current measuring terminal (42) that is composed of the plural probe pins arranged thereon and is disposed on the linear electrode so as to measure a current characteristics of the solar battery cell; and
a voltage measuring terminal (43) that is composed of the plural probe pins arranged thereon and is disposed on the linear electrode so as to measure a voltage characteristics of the solar battery cell,
wherein
the current measuring terminal (42) and the voltage measuring terminal (43) are formed in parallel with each other; and wherein
each of the current measuring terminal (42) and the voltage measuring terminal (43) is composed of the probe pins (4) that are arranged in a zig-zag pattern.

3. The solar battery measurement jig according to claim 2, wherein each of the current measuring terminal (42) and the voltage measuring terminal (43) is composed of the mutually adjacent probe pins (4) that are partially overlapped with each other in a direction orthogonal to the arrangement direction.

4. The solar battery measurement jig according to claim 3, wherein the overlapped width is up to 0.1 mm.

5. The solar battery measurement jig according to any one of claims 1 to 4, further comprising:
rocking means for rocking the probe pins (4) in a longitudinal direction.

6. An output measuring method of a solar battery cell, comprising the steps of:
preparing a solar battery measurement jig (1) as recited in any of claims 1-5 provided with: a plurality of probe pins (4) that are made in contact with a linear electrode formed on a surface of the solar battery cell and a holder (5) for holding the probe pins (4);
disposing on the linear electrode a current measuring terminal that is composed of the plural probe pins (4) that are arranged thereon so as to measure a current characteristics of the solar battery cell, and a voltage measuring terminal (43) that is composed of the plural probe pins (4) that are arranged thereon and is formed in parallel with the current measuring terminal so as to measure a voltage characteristics of the solar battery cell, and
measuring electrical characteristics, while irradiating a surface of the solar battery cell with light.

7. The output measuring method of a solar cell battery according to claim 6, wherein the solar battery cell has a busbarless structure.

8. The output measuring method of a solar cell battery according to claim 6 or 7, further comprising the step of:
allowing load means to apply a load onto the current measuring terminal and the voltage measuring terminal (43), with a total load being set in a range of 430 to less than 3000 g.

9. An output measuring method of a solar battery cell, comprising the steps of:
using a solar battery measurement jig (1) as recited in any of claims 1-5 provided with: a plurality of probe pins (4) that are made in contact with a linear electrode formed on a surface of the solar battery cell (2) and form a measuring terminal for use in measuring electrical characteristics of the solar battery cell (2); and a holder (5) for holding the probe pins (4), with the plural probe pins (4) being arranged along the longitudinal direction of the holder, and with the mutually adjacent probe pins (4) being partially overlapped with each other in the arrangement direction;
disposing the probe pins (4) forming the measuring terminal on the linear electrode; and
measuring electrical characteristics while irradiating a surface of the solar battery cell (2) with light.

10. The output measuring method of a solar battery cell according to claim 9 wherein the solar battery cell (2) has a busbarless structure.

11. The output measuring method of a solar battery cell (2) according to claim 9 or 10, further comprising the step of:
allowing load means to apply a load onto the measuring terminal, with a total load being set in a range of 430 to less than 3000 g.

## Patentansprüche

1. Messvorrichtung (1) für eine Solarbatterie, umfassend:
eine Vielzahl von Messfühlerstiften (4), die mit einer auf einer Oberfläche einer Solarbatteriezelle (2) ausgebildeten linearen Elektrode in Kontakt gebracht werden;
einen Halter (5), um die Messfühlerstifte (4) zu halten;
einen Strommessanschluss (42), der aus den darauf angeordneten mehreren Messfühlerstiften besteht und auf der linearen Elektrode angeordnet wird, um eine Stromcharakteristik der Solarbatteriezelle zu messen; und
einen Spannungsmessanschluss (43), der aus den darauf angeordneten mehreren Messfühlerstiften besteht und auf der linearen Elektrode angeordnet wird, um eine Spannungscharakteristik der Solarbatteriezelle zu messen,
wobei
der Strommessanschluss (42) und der Spannungsmessanschluss (43) parallel zueinander ausgebildet sind;
jeder des Strommessanschlusses (42) und des Spannungsmessanschlusses (43) aus den Messfühlerstiften (4) besteht, die linear angeordnet sind; und wobei
jeder des Strommessanschlusses (42) und des Spannungsmessanschlusses (43) aus den Messfühlerstiften (4) besteht, die in der Anordnungsrichtung miteinander teilweise überlappend angeordnet sind.

2. Messvorrichtung (1) für eine Solarbatterie, umfassend:
eine Vielzahl von Messfühlerstiften (4), die mit einer auf einer Oberfläche einer Solarbatteriezelle (2) ausgebildeten linearen Elektrode in Kontakt gebracht werden;
einen Halter (5), um die Messfühlerstifte (4) zu halten;
einen Strommessanschluss (42), der aus den darauf angeordneten mehreren Messfühlerstiften besteht und auf der linearen Elektrode angeordnet wird, um eine Stromcharakteristik der Solarbatteriezelle zu messen; und
einen Spannungsmessanschluss (43), der aus den darauf angeordneten mehreren Messfühlerstiften besteht und auf der linearen Elektrode angeordnet wird, um eine Spannungscharakteristik der Solarbatteriezelle zu messen,
wobei
der Strommessanschluss (42) und der Spannungsmessanschluss (43) parallel zueinander ausgebildet sind; und wobei
jeder des Strommessanschlusses (42) und des Spannungsmessanschlusses (43) aus den Messfühlerstiften (4) besteht, die in einem ZickzackMuster angeordnet sind.

3. Messvorrichtung für eine Solarbatterie nach Anspruch 2, wobei jeder des Strommessanschlusses (42) und des Spannungsmessanschlusses (43) aus den wechselseitig benachbarten Messfühlerstiften (4) besteht, die in einer zu der Anordnungsrichtung orthogonalen Richtung teilweise überlappend angeordnet sind.

4. Messvorrichtung für eine Solarbatterie nach Anspruch 3, wobei die Überlappungsbreite bis zu 0,1 mm beträgt.

5. Messvorrichtung für eine Solarbatterie nach einem der Ansprüche 1 bis 4, ferner umfassend:
ein Kipphebelmittel, um die Messfühlerstifte (4) in einer longitudinalen Richtung zu bewegen.

6. Ausgangsmessverfahren einer Solarbatteriezelle, umfassend die Schritte:
Vorbereiten einer Messvorrichtung (1) für eine Solarbatterie nach einem der Ansprüche 1 - 5, die versehen ist mit:
einer Vielzahl von Messfühlerstiften (4), die mit einer auf einer Oberfläche der Solarbatteriezelle ausgebildeten linearen Elektrode in Kontakt gebracht werden, und einem Halter (5), um die Messfühlerstifte (4) zu halten;
Anordnen, auf der linearen Elektrode, eines Strommessanschlusses, der aus den mehreren Messfühlerstiften (4) besteht, die darauf angeordnet sind, um eine Stromcharakteristik der Solarzellenbatterie zu messen, und eines Spannungsmessanschlusses (43), der aus den mehreren Messfühlerstiften (4) besteht, die darauf angeordnet sind, und parallel zu dem Strommessanschluss ausgebildet ist, um eine Spannungscharakteristik der Solarbatteriezelle zu messen, und
Messen elektrischer Charakteristiken, während eine Oberfläche der Solarbatteriezelle mit Licht bestrahlt wird.

7. Ausgangsmessverfahren einer Solarzellenbatterie nach Anspruch 6, wobei die Solarbatteriezelle eine sammelschienenlose Struktur aufweist.

8. Ausgangsmessverfahren einer Solarzellenbatterie nach Anspruch 6 oder 7, ferner umfassend den Schritt:
Zulassen, dass ein Lastmittel eine Last auf den Strommessanschluss und den Spannungsmessanschluss (43) anwendet, wobei eine Gesamtlast in einem Bereich von 430 bis weniger als 3000 g eingestellt wird.

9. Ausgangsmessverfahren einer Solarbatteriezelle, umfassend die Schritte:
Verwenden einer Messvorrichtung (1) für eine Solarbatterie nach einem der Ansprüche 1 - 5, die versehen ist mit:
einer Vielzahl von Messfühlerstiften (4), die mit einer auf einer Oberfläche der Solarbatteriezelle (2) ausgebildeten linearen Elektrode in Kontakt gebracht werden und einen Messanschluss zur Verwendung beim Messen elektrischer Charakteristiken der Solarbatteriezelle (2) bilden; und einem Halter (5), um die Messfühlerstifte (4) zu halten, wobei die mehreren Messfühlerstifte (4) entlang der Längsrichtung des Halters angeordnet sind und wobei die wechselseitig benachbarten Messfühlerstifte (4) in der Anordnungsrichtung miteinander teilweise überlappend angeordnet sind;
Anordnen der Messfühlerstifte (4), die den Messanschluss bilden, auf der linearen Elektrode; und
Messen der elektrischen Charakteristiken, während eine Oberfläche der Solarbatteriezelle (2) mit Licht bestrahlt wird.

10. Ausgangsmessverfahren einer Solarbatteriezelle nach Anspruch 9, wobei die Solarbatteriezelle (2) eine sammelschienenlose Struktur aufweist.

11. Ausgangsmessverfahren einer Solarbatteriezelle (2) nach Anspruch 9 oder 10, ferner umfassend den Schritt:
Zulassen, dass ein Lastmittel eine Last auf den Messanschluss anwendet, wobei eine Gesamtlast in einem Bereich von 430 bis weniger als 3000 g eingestellt wird.

## Revendications

1. Montage de mesure de batterie solaire (1) comprenant :
plusieurs broches de sondes (4) qui sont mises en contact avec une électrode linéaire formée sur une surface d'un élément de batterie solaire (2) ;
un support (5) pour tenir les broches de sondes (4) ;
une borne de mesure de courant (42) qui se compose des broches de sondes disposées sur elle, et qui est disposée sur l'électrode linéaire de manière à mesurer une courbe caractéristique de courant de l'élément de batterie solaire ; et
une borne de mesure de tension (43) qui se compose des broches de sondes disposées sur elle, et qui est disposée sur l'électrode linéaire de manière à mesurer une courbe caractéristique de tension de l'élément de batterie solaire,
la borne de mesure de courant (42) et la borne de mesure de tension (43) étant formées parallèlement l'une par rapport à l'autre ;
la borne de mesure de courant (42) et la borne de mesure de tension (43) se composant chacune des broches de sondes (4) qui sont disposées linéairement ; et
la borne de mesure de courant (42) et la borne de mesure de tension (43) se composant chacune des broches de sondes (4) qui se recouvrent en partie dans le sens de disposition.

2. Montage de mesure de batterie solaire (1) comprenant :
plusieurs broches de sondes (4) qui sont mises en contact avec une électrode linéaire formée sur une surface d'un élément de batterie solaire (2) ;
un support (5) pour tenir les broches de sondes (4) ;
une borne de mesure de courant (42) qui se compose des broches de sondes disposées sur elle, et qui est disposée sur l'électrode linéaire de manière à mesurer une courbe caractéristique de courant de l'élément de batterie solaire ; et
une borne de mesure de tension (43) qui se compose des broches de sondes disposées sur elle, et qui est disposée sur l'électrode linéaire de manière à mesurer une courbe caractéristique de tension de l'élément de batterie solaire,
la borne de mesure de courant (42) et la borne de mesure de tension (43) étant formées parallèlement l'une par rapport à l'autre ; et
la borne de mesure de courant (42) et la borne de mesure de tension (43) se composant chacune des broches de sondes (4) qui sont disposées en zigzag.

3. Montage de mesure de batterie solaire selon la revendication 2, dans lequel la borne de mesure de courant (42) et la borne de mesure de tension (43) se composent chacune des broches de sondes (4) mutuellement adjacentes, qui se recouvrent en partie dans un sens orthogonal par rapport au sens de disposition.

4. Montage de mesure de batterie solaire selon la revendication 3, dans lequel la largeur de recouvrement va jusqu'à 0,1 mm.

5. Montage de mesure de batterie solaire selon l'une quelconque des revendications 1 à 4, comprenant également :
des moyens de basculement pour basculer les broches de sondes (4) dans un sens longitudinal.

6. Procédé de mesure de sortie d'un élément de batterie solaire, comprenant les étapes qui consistent à :
préparer un montage de mesure de batterie solaire (1) tel qu'il est présenté dans l'une quelconque des revendications 1 à 5, pourvu : de plusieurs broches de sondes (4) qui sont mises en contact avec une électrode linéaire formée sur une surface de l'élément de batterie solaire, et d'un support (5) pour tenir les broches de sondes (4) ;
placer sur l'électrode linéaire une borne de mesure de courant qui se compose des broches de sondes (4) disposées sur elle, de manière à mesurer une courbe caractéristique de courant de l'élément de batterie solaire, et une borne de mesure de tension (43) qui se compose des broches de sondes (4) disposées sur elle, et qui est formée parallèlement à la broche de mesure de courant de manière à mesurer une courbe caractéristique de tension de l'élément de batterie solaire, et
mesurer une courbe caractéristique électrique en exposant une surface de l'élément de batterie solaire à la lumière.

7. Procédé de mesure de sortie d'un élément de batterie solaire selon la revendication 6, l'élément de batterie solaire ayant une structure sans barre omnibus.

8. Procédé de mesure de sortie d'un élément de batterie solaire selon la revendication 6 ou 7, comprenant également l'étape qui consiste à :
permettre à des moyens de charge d'appliquer une charge à la borne de mesure de courant et à la borne de mesure de tension (43), une charge totale étant fixée dans une plage de 430 à moins de 3000 g.

9. Procédé de mesure de sortie d'un élément de batterie solaire, comprenant les étapes qui consistent à :
utiliser un montage de mesure de batterie solaire (1) tel qu'il est présenté dans l'une quelconque des revendications 1 à 5, pourvu : de plusieurs broches de sondes (4) qui sont mises en contact avec une électrode linéaire formée sur une surface de l'élément de batterie solaire (2), et qui forment une borne de mesure à utiliser pour mesurer une courbe caractéristique électrique de l'élément de batterie solaire (2) ; et d'un support (5) pour tenir les broches de sondes (4), les broches de sondes (4) étant disposées de la long du sens longitudinal du support, et les broches de sondes (4) mutuellement adjacentes se recouvrant en partie dans le sens de disposition ;
placer les broches de sondes (4) qui forment la borne de mesure sur l'électrode linéaire ; et
mesurer une courbe caractéristique électrique en exposant une surface de l'élément de batterie solaire (2) à la lumière.

10. Procédé de mesure de sortie d'un élément de batterie solaire selon la revendication 9, l'élément de batterie solaire (2) ayant une structure sans barre omnibus.

11. Procédé de mesure de sortie d'un élément de batterie solaire (2) selon la revendication 9 ou 10, comprenant également l'étape qui consiste à :
permettre à des moyens de charge d'appliquer une charge à la borne de mesure, une charge totale étant fixée dans une plage de 430 à moins de 3000 g.
